# EUROPÄISCHE PATENTANMELDUNG

(11) **EP 1 176 605 A2**
(43) Veröffentlichungstag der Anmeldung: **30.01.2002**
(21) Anmeldenummer: 01113437.6
(22) Anmeldetag: 01.06.2001
(51) Int. Cl.: G11C 29/00, G11C 11/15, G11C 11/16

(54) **Integrierter Speicher mit Speicherzellen mit magnetoresistivem Speichereffekt**

(30) Priorität: 20.06.2000 DE 10030234
(71) Anmelder: Infineon Technologies AG, 81669 München (DE)
(72) Erfinder: Hartmann, Udo, 81541 München (DE)
(74) Vertreter: Epping Hermann & Fischer

(57) **Zusammenfassung**

Ein integrierter Speicher enthält Speicherzellen (MC) mit magnetoresistivem Speichereffekt sowie Spaltenleitungen (BL0 bis BLn) und Zeilenleitungen (WL0 bis WLm). Die Speicherzellen (MC) sind jeweils zwischen eine der Spaltenleitungen (BL0 bis BLn) und eine der Zeilenleitungen (WL0 bis WLm) geschaltet. Sie sind derart ausgeführt, daß sie von der jeweiligen Spaltenleitung (BL0 bis BLn) und/oder Zeilenleitung (WL0 bis WLm) mittels eines Stromflusses (IB) durch die jeweilige Speicherzelle (MC) abtrennbar sind. Dadurch ist im Falle einer vorhandenen fehlerhaften Speicherzelle (MCl2) ein vergleichsweise geringer Reparaturaufwand des Speichers ermöglicht.

## Beschreibung

Die vorliegende Erfindung betrifft einen integrierten Speicher mit Speicherzellen mit magnetoresistivem Speichereffekt, die jeweils zwischen eine von mehreren Spaltenleitungen und eine von mehreren Zeilenleitungen geschaltet sind.

Speicherzellen mit magnetoresistivem Speichereffekt weisen zur Speicherung von Datensignalen im allgemeinen in ihrem Zustand veränderbare ferromagnetische Schichten auf. Dieser Speichereffekt ist allgemein als sogenannter GMR-Effekt (giant magnetoresistive) oder TMR-Effekt (tunneling magnetoresistive) bekannt. Dabei ist der elektrische Widerstand einer derartigen Speicherzelle abhängig von der Magnetisierung in den ferromagnetischen Schichten.

Integrierte Speicher mit derartigen Speicherzellen, auch als sogenannte MRAM-Speicher bezeichnet, sind oftmals ähnlich aufgebaut wie beispielsweise integrierte Speicher vom Typ DRAM. Derartige Speicher weisen im allgemeinen eine Speicherzellenanordnung mit untereinander im wesentlichen parallel verlaufenden Zeilenleitungen und Spaltenleitungen auf, wobei die Zeilenleitungen üblicherweise quer zu den Spaltenleitungen verlaufen.

Ein derartiger MRAM-Speicher ist aus WO99/14760 bekannt. Dort sind die Speicherzellen jeweils zwischen eine der Zeilenleitungen und eine der Spaltenleitungen geschaltet und mit der jeweiligen Spaltenleitung und Zeilenleitung elektrisch verbunden. Die Speicherzellen mit magnetoresistivem Speichereffekt sind dabei hochohmiger als die Zeilenleitungen und Spaltenleitungen. Die Spaltenleitungen sind zum Auslesen eines Datensignals einer der Speicherzellen mit einem Leseverstärker verbunden. Zum Auslesen wird der auf der Spaltenleitung detektierbare Strom gemessen.

Bei einem derartigen MRAM-Speicher sind keine Dioden oder Transistoren wie bei einem DRAM-Speicher vorhanden, die zum Auslesen eines Datensignals die Speicherzellen abhängig von der Adressierung mit der jeweiligen Spaltenleitung verbinden. Dadurch erhält man insbesondere Vorteile bei der geometrischen Anordnung der Speicherzellen. Insbesondere kann durch eine gestapelte Anordnung der Speicherzellen eine Platzersparnis bei der Anordnung der Speicherzellen erzielt werden.

Infolge von herstellungsbedingten Einflüssen wie beispielsweise Prozeßschwankungen oder infolge von Alterung ist es möglich, daß einzelne der Speicherzellen einen unerwünschten vergleichsweise niedrigen Widerstand aufweisen und damit fehlerhaft sind. Über derartige fehlerhafte Speicherzellen sind jeweilige angeschlossene Spaltenleitungen und Zeilenleitungen im wesentlichen kurzgeschlossen. Durch einen solchen Kurzschluß sind auch weitere Speicherzellen entlang dieser Spaltenleitung beziehungsweise Zeilenleitung betroffen. Weiterhin können in einem Funktionstest infolge eines Kurzschlusses durch eine der Speicherzellen andere Speicherzellen, welche entlang von betroffenen Leitungen liegen, nicht mehr getestet werden. Bei einer Reparatur eines Speichers mit einer defekten Speicherzelle läßt sich das Problem nicht durch Ersetzen einer einzelnen betroffenen Zeilenleitung oder Spaltenleitung beseitigen, da die Speicherzellen der anderen betroffenen Leitung nach wie vor durch den Kurzschluß in ihrer Funktion beeinträchtigt sind. Es sind in diesem Falle daher beide betroffene Leitungen einer fehlerhaften Speicherzelle zu ersetzen.

Die Aufgabe der vorliegenden Erfindung ist es, einen integrierten Speicher der eingangs genannten Art anzugeben, bei dem im Falle einer vorhandenen fehlerhaften Speicherzelle, die einen Kurzschluß zwischen einer Zeilenleitung und einer Spaltenleitung auslöst, der Aufwand zur Reparatur des Speichers reduzierbar ist.

Die Aufgabe wird gelöst durch einen integrierten Speicher mit Speicherzellen mit magnetoresistivem Speichereffekt, die jeweils zwischen eine von mehreren Spaltenleitungen und eine von mehreren Zeilenleitungen geschaltet und mit der jeweiligen Spaltenleitung und Zeilenleitung elektrisch verbunden sind, bei dem die Speicherzellen derart ausgeführt sind, daß sie von der jeweiligen Spaltenleitung und/oder Zeilenleitung mittels eines Stromflusses durch die jeweilige Speicherzelle abtrennbar sind, so daß die jeweilige elektrische Verbindung unterbrochen ist.

Bei dem erfindungsgemäßen integrierten Speicher ist es möglich, bei Auftreten von fehlerhaften Speicherzellen, die einen Kurzschluß zwischen der jeweiligen angeschlossenen Zeilenleitung und Spaltenleitung auslösen, diese so abzutrennen, daß die jeweilige elektrische Verbindung unterbrochen ist. Dadurch wird der Kurzschluß zwischen der betroffenen Zeilenleitung und Spaltenleitung unterbrochen. Dadurch sind die an einer fehlerhaften Speicherzelle angeschlossene Spaltenleitung und Zeilenleitung und die daran angeschlossenen Speicherzellen nicht mehr von dem Kurzschluß betroffen. Die an einer fehlerhaften Speicherzelle angeschlossene Spaltenleitung und Zeilenleitung können beispielsweise für einen Normalbetrieb oder Testbetrieb des integrierten Speichers weiterverwendet werden. Der Aufwand zum Abtrennen der Speicherzelle ist dabei relativ gering. Es müssen prinzipiell keine Leitungen ersetzt werden.

Der integrierte Speicher weist vorzugsweise zur Reparatur von fehlerhaften Speicherzellen redundante Speicherzellen auf, die zu wenigstens einer redundanten Zeilenleitung und/oder redundanten Spaltenieitung zusammengefaßt sind, die reguläre Leitungen mit defekten Speicherzellen adressenmäßig ersetzen können. Dabei wird der integrierte Speicher beispielsweise mit einer externen Prüfeinrichtung geprüft und anschließend anhand einer sogenannten Redundanzanalyse eine Programmierung der redundanten Elemente vorgenommen. Eine Redundanzschaltung weist dann programmierbare Elemente zum Beispiel in Form von programmierbaren Fuses auf, die zum Speichern der Adresse einer zur ersetzenden Leitung dienen.

Zur Reparatur des integrierten Speichers im Falle einer vorhandenen fehlerhaften Speicherzelle reicht es aus, nur eine der betroffenen Leitungen durch eine redundante Leitung zu ersetzen. Da der Kurzschluß in der fehlerhaften Speicherzelle unterbrochen ist, kann die andere der betroffenen Leitungen weiterbetrieben werden. Dadurch ist der Reparaturaufwand vorteilhaft reduzierbar.

Weist der integrierte Speicher mehrere redundante Zeilenleitungen und Spaltenleitungen auf, so kann im Falle einer vorhandenen fehlerhaften Speicherzelle mit einem Funktionstest für die restlichen Speicherzellen beispielsweise entlang der angeschlossenen Zeilenleitung fortgefahren werden, wenn die fehlerhafte Speicherzelle zuvor von der betroffenen Zeilenleitung getrennt wird. Auf diese Weise können insgesamt alle Speicherzellen des integrierten Speichers getestet werden, auch wenn zwischendurch fehlerhafte Speicherzellen auftreten. Dies hat den Vorteil, daß anhand einer nachfolgenden Redundanzanalyse eine gezielte optimierte Programmierung der redundanten Leitungen vorgenommen werden kann. Da die Anzahl der redundanten Leitungen meistens begrenzt ist, kann auf diese Weise die Ausbeute von herzustellenden integrierten Speichern erhöht werden.

In einer Ausführungsform des erfindungsgemäßen Speichers ist der Stromfluß zum Abtrennen einer fehlerhaften Speicherzelle gegenüber einem Stromfluß zum Auslesen von Datensignalen aus einer der Speicherzellen oder zum Einschreiben von Datensignalen in eine der Speicherzellen erhöht. Der Stromfluß zum Abtrennen einer fehlerhaften Speicherzelle wird beispielsweise durch eine von extern angeschlossene Stromquelle erzeugt. Dabei wird vorteilhaft eine Oberspannungsgrenze definiert, so daß beim Einspeisen des erhöhten Stromes eine vorgegebene Spannung nicht überschritten wird.

In einer vorteilhaften Ausführungsform des erfindungsgemäßen integrierten Speichers sind zwischen den Speicherzellen und der jeweiligen angeschlossenen Spaltenleitung und/oder zwischen den Speicherzellen und der jeweiligen angeschlossenen Zeilenleitung jeweils elektrische Leiterbahnen vorgesehen. Die Leiterbahnen weisen eine Sollbruchstelle auf, die durch den Stromfluß zum Abtrennen einer fehlerhaften Speicherzelle durchtrennbar ist. Die Sollbruchstelle wird beispielsweise durch eine Verjüngung der Breite der jeweiligen Leiterbahn erreicht. Die Verjüngung ist dabei derart ausgebildet, daß die jeweilige Leiterbahn durch den Stromfluß zum Abtrennen der fehlerhaften Speicherzelle aufgetrennt wird.

In einer anderen Ausführungsform des erfindungsgemäßen integrierten Speichers weisen die Speicherzellen ein elektrisch abtrennbares Material auf, das zwischen die Speicherzellen und die jeweilige Spaltenleitung und/oder Zeilenleitung geschaltet ist. Dieses Material ist dabei derart ausgebildet, daß durch den Stromfluß zum Abtrennen einer fehlerhaften Speicherzelle die elektrische Verbindung zwischen der Speicherzelle und einer der beiden angeschlossenen Leitungen oder beiden Leitungen unterbrochen ist. Das abtrennbare Material ist dazu vorteilhaft schichtartig auf die Speicherzellen aufgebracht.

Weitere vorteilhafte Aus- und Weiterbildungen sind in Unteransprüchen gekennzeichnet.

Im folgenden wird die Erfindung anhand der in der Zeichnung dargestellten Figuren, die Ausführungsbeispiele darstellen, näher erläutert. Es zeigen
- Figur 1: eine Ausführungsform des erfindungsgemäßen integrierten Speichers mit magnetoresistiven Speicherzellen,
- Figur 2: eine Ausführungsform einer Speicherzelle mit angeschlossener Zeilenleitung und Spaltenleitung,
- Figur 3: eine weitere Ausführungsform einer Speicherzelle mit angeschlossener Zeilenleitung und Spaltenleitung.

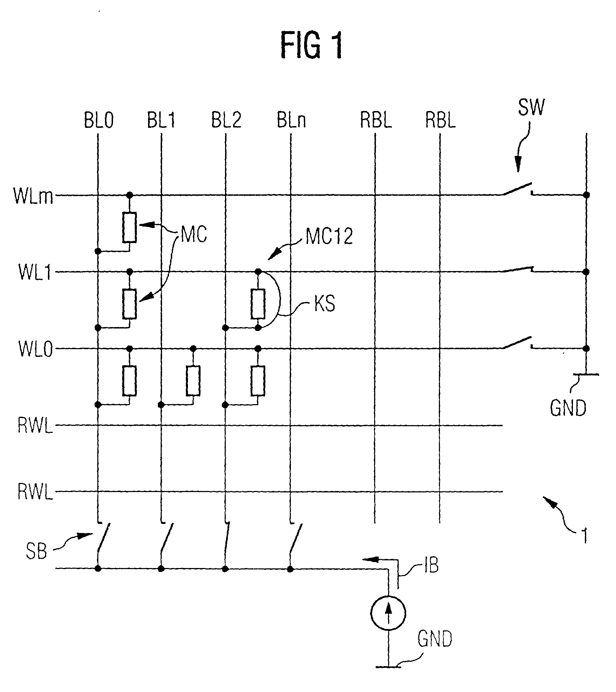

Figur 1 zeigt ein Ausführungsbeispiel eines erfindungsgemäßen Speichers mit Speicherzellen MC mit magnetoresistivem Speichereffekt. Als Speicherzellen sind alle bekannten GMR-/TMR-Elemente geeignet, sofern sie hochohmiger sind als die Spaltenleitungen, hier als Bitleitungen BL0 bis BLn bezeichnet, und die Zeilenleitungen, hier als Wortleitungen WL0 bis WLm bezeichnet. Der Speicher weist hier eine beispielhafte Anzahl von Wortleitungen und Bitleitungen auf. Die Speicherzellen MC, die in einem matrixförmigen Speicherzellenfeld 1 angeordnet sind, sind jeweils zwischen eine der Bitleitungen BL0 bis BLn und eine der Wortleitungen WL0 bis WLm geschaltet.

Zum Auslesen eines Datensignals aus einer der Speicherzellen MC ist die entsprechende Bitleitung beispielsweise mit einem Leseverstärker verbunden, der in Figur 1 nicht dargestellt ist. Zum Auslesen einer in einer Speicherzelle gespeicherten Information wird die betreffende Wortleitung angesteuert. Diese wird dazu mit einem vorgegebenen Potential beaufschlagt, so daß ein Stromfluß durch die auszulesende Speicherzelle auftritt. Alle anderen Wortleitungen werden auf beispielsweise Bezugspotential gelegt. Die an der auszulesenden Speicherzelle angeschlossene Bitleitung wird zum Auslesen eines Datensignals mit einem entsprechenden Leseverstärker verbunden, der diesen Stromfluß detektiert.

Die in Figur 1 gezeigte Speicherzelle MC12 ist an der Wortleitung WL1 und Bitleitung BL2 angeschlossen. Die Speicherzelle MC12 sei als fehlerhaft angenommen. Über die Speicherzelle MC12 sind die Bitleitung BL2 und Wortleitung WL1 kurzgeschlossen, in Figur 1 schematisch dargestellt durch einen Kurzschlußbogen KS. Bleibt dieser Kurzschluss beispielsweise während eines Normalbetriebs des Speichers bestehen, so kann bei einer Auswahl von Speicherzellen entlang der Wortleitung WL1 oder Bitleitung BL2 kein ordnungsgemäßer Auslesevorgang oder Schreibvorgang erfolgen. In diesem Fall wird der Stromfluß zum Auslesen oder Einschreiben von Datensignalen durch den Stromfluß überlagert, der durch den Kurzschluß in der Speicherzelle MC12 hervorgerufen wird.

Erfindungsgemäß ist die Speicherzelle MC12 derart ausgeführt, dass sie von der Bitleitung BL2 und/oder Wortleitung WL1 mittels des Stroms IB abtrennbar ist. Der Strom IB wird hier von einer externen Stromquelle bereitgestellt und ist gegenüber einem Strom zum Auslesen oder Einschreiben eines Datensignals erhöht. Auf diese Weise kann die kurzgeschlossene elektrische Verbindung zwischen der Bitleitung BL2 und der Wortleitung WL1 unterbrochen werden. Die Speicherzelle MC12 wird dabei durch die Schalter SB und SW in geeigneter Weise adressiert. Die Stromquelle zur Erzeugung des Stroms IB und die Wortleitung WL1 sind jeweils mit einem Bezugspotential GND des Speichers verbunden.

Die Speicherzellen MC des Speicherzellenfeldes 1 werden beispielsweise in einem Funktionstest hinsichtlich deren Funktionsfähigkeit geprüft. Wird dabei eine fehlerhafte Speicherzelle MC festgestellt, so kann diese in der beschriebenen Art abgetrennt werden. Das Speicherzellenfeld 1 kann dadurch vollständig getestet werden, ohne daß ein unerwünschter Kurzschlußstrom auftritt. Bei Auftreten von fehlerhaften Speicherzellen MC können betroffene Wortleitungen WL0 bis WLm beziehungsweise betroffene Bitleitungen BL0 bis BLn durch redundante Wortleitungen RWL oder redundante Bitleitungen RBL ersetzt werden. Durch vollständiges Testen des Speicherfeldes 1 ist eine vollständige Redundanzanalyse durchführbar, anhand deren eine gezielte optimierte Programmierung der redundanten Wortleitungen RWL beziehungsweise redundanten Bitleitungen RBL erfolgen kann.

Es ist prinzipiell auch möglich, den Speicher ohne Ersatz durch eine redundante Leitung weiterzubetreiben. Allerdings ist die betreffende Speicherzelle defekt, was den Betrieb beeinträchtigen kann. Bei einer Reparatur mit einer redundanten Leitung braucht nur die betroffene Wortleitung oder Bitleitung (in Figur 1 WL1 oder BL2) ersetzt werden.

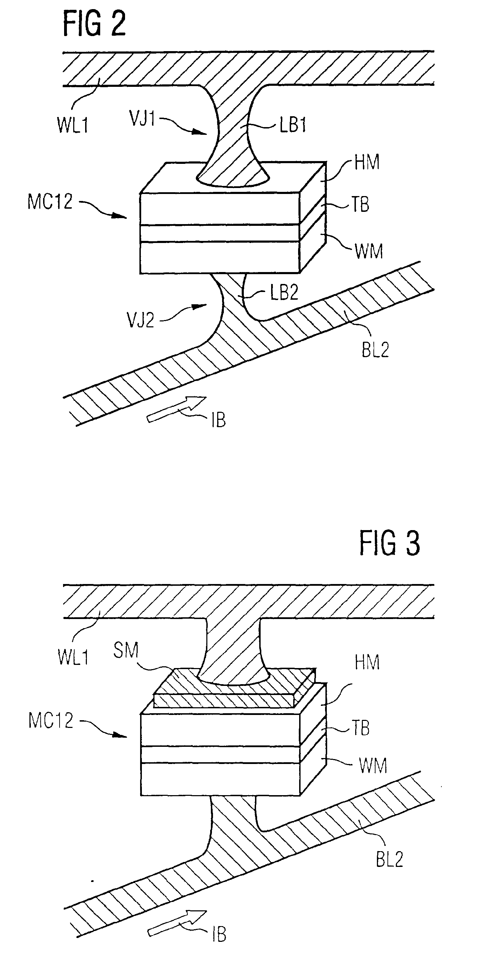

Figur 2 zeigt eine Ausführungsform der Speicherzelle MC12, die an der Wortleitung WL1 und Bitleitung BL2 angeschlossen ist. Zwischen der Speicherzelle MC12 und der Wortleitung WL1 ist eine elektrische Leiterbahn LB1 vorgesehen. Zwischen der Speicherzelle MC12 und der Bitleitung BL2 ist die Leiterbahn LB2 vorgesehen. Hier weisen vorzugsweise beide Leiterbahnen LB1 und LB2 jeweils eine Sollbruchstelle auf in Form der Verjüngung VJ1 beziehungsweise VJ2. An der jeweiligen Verjüngung ist die Leiterbahn LB1 beziehungsweise LB2 in ihrer Breite beziehungsweise in ihrem Durchmesser reduziert. Die Breiten der Leiterbahnen LB1 und LB2 sind derart bemessen, daß sie durch den erhöhten Stromfluß IB zum Abtrennen der Speicherzelle MC12 durchtrennbar sind. Die Speicherzelle MC12 ist aus drei Schichten aufgebaut. Sie weist eine hartmagnetische Schicht HM, eine Tunnelbarriere TB und eine weichmagnetische Schicht WM auf.

Figur 3 zeigt eine weitere Ausführungsform der Speicherzelle MC12. In diesem Beispiel ist zwischen der Speicherzelle MC12 und der Wortleitung WL1 ein schichtartiges Material SM angeordnet, das elektrisch abtrennbar bzw. durchtrennbar ist. Das schichtartige Material SM kann zusätzlich oder alternativ auch zwischen die Speicherzelle MC12 und der Bitleitung BL2 angeordnet werden. Wie auch in Figur 2 wird hier durch einen Stromfluß IB durch die Speicherzelle MC12 diese mittels der Schicht SM abgetrennt, so daß die elektrische Verbindung zwischen der Speicherzelle MC12 und der Wortleitung WL1 unterbrochen ist.

## Patentansprüche

1. Integrierter Speicher mit Speicherzellen (MC) mit magnetoresistivem Speichereffekt, die jeweils zwischen eine von mehreren Spaltenleitungen (BL0 bis BLn) und eine von mehreren Zeilenleitungen (WL0 bis WLm) geschaltet und mit der jeweiligen Spaltenleitung (BL0 bis BLn) und Zeilenleitung (WL0 bis WLm) elektrisch verbunden sind,
**dadurch gekennzeichnet, daß**
die Speicherzellen (MC) derart ausgeführt sind, daß sie von der jeweiligen Spaltenleitung (BL0 bis BLn) und/oder Zeilenleitung (WL0 bis WLm) mittels eines Stromflusses (IB) durch die jeweilige Speicherzelle (MC) abtrennbar sind, so daß die jeweilige elektrische Verbindung unterbrochen ist.

2. Integrierter Speicher nach Anspruch 1,
**dadurch gekennzeichnet, daß**
der Stromfluß (IB) zum Abtrennen einer der Speicherzellen (MC) gegenüber einem Stromfluß zum Auslesen von Datensignalen aus einer der Speicherzellen (MC) oder zum Einschreiben von Datensignalen in eine der Speicherzellen (MC) erhöht ist.

3. Integrierter Speicher nach einem der Ansprüche 1 oder 2,
**dadurch gekennzeichnet, daß**
zwischen der jeweiligen Speicherzelle (MC12) und der jeweiligen Spaltenleitung (BL2) und/oder zwischen der jeweiligen Speicherzelle (MC12) und der jeweiligen Zeilenleitung (WL1) eine elektrische Leiterbahn (LB1, LB2) vorgesehen ist, die eine Sollbruchstelle (VJ1, VJ2) aufweist, die durch den Stromfluß (IB) zum Abtrennen der Speicherzelle (MC12) durchtrennbar ist.

4. Integrierter Speicher nach Anspruch 3,
**dadurch gekennzeichnet, daß**
die Leiterbahn (LB1, LB2) an der Sollbruchstelle (VJ1, VJ2) eine Verjüngung ihrer Breite aufweist.

5. Integrierter Speicher nach einem der Ansprüche 1 oder 2,
**dadurch gekennzeichnet, daß**
die jeweilige Speicherzelle (MC12) ein elektrisch abtrennbares Material (SM) aufweist, das zwischen die Speicherzelle (MC12) und die jeweilige Spaltenleitung (BL2) und/oder Zeilenleitung (WL1) geschaltet ist.

6. Integrierter Speicher nach Anspruch 5,
**dadurch gekennzeichnet, daß**
das abtrennbare Material (SM) schichtartig auf die jeweilige Speicherzelle (MC12) aufgebracht ist.

7. Integrierter Speicher nach einem der Ansprüche 1 bis 6,
**dadurch gekennzeichnet, daß**
der integrierte Speicher wenigstens eine redundante Zeilenleitung (RWL) und/oder redundante Spaltenleitung (RBL) aufweist zum Ersetzen einer der Zeilenleitungen (WL0 bis WLm) beziehungsweise einer der Spaltenleitungen (BL0 bis BLn).
